# EUROPÄISCHE PATENTSCHRIFT

(11) **EP 1 832 151 B1**
(45) Veröffentlichungstag und Bekanntmachung des Hinweises auf die Patenterteilung: **06.02.2008**
(21) Anmeldenummer: 05819535.5
(22) Anmeldetag: 14.12.2005
(51) Int. Cl.: H05K 7/20, D01H 1/00

(54) **VERFAHREN UND VORRICHTUNG ZUM KÜHLEN EINER LEISTUNGSELEKTRONIK DER ANTRIEBSAGGREGATE EINER TEXTILMASCHINE**
METHOD AND DEVICE FOR COOLING A POWER CIRCUIT IN THE DRIVE UNIT OF A TEXTILE MACHINE
PROCEDE ET DISPOSITIF POUR REFROIDIR UN SYSTEME ELECTRONIQUE DE PUISSANCE DANS LE MECANISME D'ENTRAINEMENT D'UNE MACHINE TEXTILE

(30) Priorität: 17.12.2004 DE 102004062452
(43) Veröffentlichungstag der Anmeldung: 12.09.2007
(73) Patentinhaber: Oerlikon Textile GmbH & Co. KG, 41069 Mönchengladbach (DE)
(72) Erfinder: NEUBURGER, Günter, 73337 Bad Überkingen (DE); BENKERT, Thomas, 73326 Deggingen (DE); MANN, Peter, 73095 Albershausen (DE)
(86) Internationale Anmeldenummer: PCT/EP2005/013470
(87) Internationale Veröffentlichungsnummer: WO 2006/066784

(56) Entgegenhaltungen:
- EP-A- 0 478 993
- EP-A- 1 067 831
- DE-A1- 19 612 707
- DE-A1- 19 915 235
- US-A- 4 520 425
- US-A- 4 976 098
- US-A- 5 617 307

## Beschreibung

Die Erfindung betrifft ein Verfahren und eine Vorrichtung zum Kühlen der Leistungselektronik von Antriebsaggregaten von Textilmaschinen. Speziell betrifft sie einen Frequenzumrichter bzw. Frequenzumformer für den Antrieb einer Textilmaschine, mit einem Gleichrichter zum Gleichrichten von Wechselstrom, einem Zwischenkreis zum Glätten des pulsierenden Gleichstroms, einem Wechselsrichter zum Erzeugen von Wechselstrom anderer Frequenz und mit einer Steuervorrichtung zum Steuern dieser Bauteile.

Frequenzumformer zum Umformen eines Wechselstromes erster Frequenz in einen Wechselstrom zweiter, anderer, in aller Regel veränderbarer Frequenz umfassen in aller Regel einen Gleichrichter zum Umsetzen des Wechselstromes erster Frequenz in einen Gleichstrom, einen Zwischenkreis zu Glätten des pulsierenden Gleichstroms, einen Wechselrichter zum Erzeugen von Wechselstrom der angestrebten zweiten Frequenz und eine Steuervorrichtung zum funktionsgerechten Steuern der genannten Bauteile. Mit Zwischenkreis ist hier nicht nur die elektrische Funktion gemeint, sondern auch die körperliche Baugruppe, die diese Funktion ausübt.

Alle Bauteile des Frequenzumformers entwickeln im Betrieb Wärme. Besonders hoch ist diese Wärmeentwicklung in dem mit Kondensatoren bestückten Zwischenkreis. Dieser Zwischenkreis ist auch gegen Überhitzung besonders anfällig. Er muss daher auch bisweilen ausgetauscht werden.

Derartige Frequenzumformer bzw. Frequenzumrichter finden beispielsweise Anwendung bei Textilmaschinen, insbesondere Spinnmaschinen und Vorspinnmaschinen. Solche Maschinen weisen bereits zum Kühlen der Antriebsaggregate und/oder Absaugen von Textilfusseln einen Kanal auf, welcher üblicherweise von kühler Luft aus dem Spinnsaal durchströmt wird.

Um ein Überhitzen stark Wärme erzeugender Leistungselektroniken zu vermeiden, werden bei derartigen Maschinen Maßnahmen getroffen, um diese Leistungselektroniken zu kühlen. So ist in der EP 0478993 A1 beispielsweise ein Verfahren und eine Vorrichtung zum Kühlen der Antriebsaggregate einer Ringspinn- oder Zwirnmaschine vorgeschlagen, bei der die Verlustwärme einer Leistungselektronik über einen Wärmetauscher abgeführt wird. Hierzu wird am Wärmetauscher ein aus einem Sammelkanal über ein Gebläse abgezweigter Teilstrom der Abluft vorbeigeführt und wiederum mit dem Hauptluftstrom einer Abluftführung zusammengeführt.

In der DE 19915235 A1 ist weiterhin eine Belüftungseinrichtung für eine Textilmaschine vorgeschlagen, welche einen Schaltschrank mit Steuerungen zum geordneten Betreiben von Antrieben der Textilmaschine kühlt. Hierzu umfasst die Belüftungseinrichtung einen Schacht mit Öffnungen für Zu- und Abluft, welcher auf der Rückseite der Steuerung liegt und einseitig durch einen Kühlkörper, welcher auf der vom Schacht abgewandten Seite Steuermodule trägt, begrenzt wird.

In der DE 196 12 707 A1 ist eine langgestreckte Spinnmaschine offenbart, die über ihre Länge verteilt mehrere Spindelmotoren aufweist. Solche Spindelmotoren bedürfen der Kühlung. Zu diesem Zweck sind sie vollständig im Abluftkanal der Fadenbruchabsaugung angeordnet. Es handelt sich hierbei jedoch nicht um Leistungselektronik oder einen abtrennbaren Teil derselben. Diese Art der Kühlung ist baulich aufwendig und kostenintensiv.

Aufgabe der Erfindung ist es daher, ein Verfahren und eine Vorrichtung zu schaffen, die auf einfache Weise einen möglichst sicheren und wartungsarmen Betrieb einer Textilmaschine gewährleistet.

Sie löst diese Aufgabe durch die in den Ansprüchen aufgeführten Merkmale

Der Grundgedanke der erfindungsgemäßen Lösung ist, Frequenzumrichter so kühl wie möglich zu halten und/oder sie wenigstens teilweise aus den warmen Bereichen der Maschine auszueinzeln. Unter "Auseinzeln" soll hier entfernen, entfernt anordnen, verlagern, wegschaffen, umsiedeln, herauslösen und dergleichen verstanden werden.

Die Erfindung schlägt insbesondere vor, im Zwischenkreis eines Frequenzumformers entwickelte Wärme wirksam abzuführen, die Übertragung der im Zwischenkreis entwickelten Wärme auf andere Bauteile des Frequenzumformers zu verhindern und ein Auswechseln des Bauteiles "Zwischenkreis"zu vereinfachen.

Durch eine räumliche Trennung des Zwischenkreises von den anderen Bauteilen des Frequenzumformers wird zunächst verhindert, dass die im Frequenzumformer entwickelnde Wärme auf diese anderen Bauteile übertragen wird. Es muss daher weniger Wärme von diesen Bauteilen abgeführt werden, was ihre Kühlhaltung vereinfacht. Die räumliche Trennung des Zwischenkreises vereinfacht und ermöglicht es auch, ihn an einem Luftkanal anzuordnen, in dem ein Luftstrom geführt wird, der zur Abfuhr der im Zwischenkreis entwickelten Wärme genutzt werden kann. Die übrigen Bauteile des Frequenzumformers können dabei an dem für sie zweckmäßigen Platz, etwa im Schaltschrank der Maschine verbleiben. Schließlich erleichtert die räumlich getrennte Anordnung des Zwischenkreises und seine Ausführung als gesonderter Modul auch seine leichte Austauschbarkeit, wenn diese erforderlich werden sollte.

Durch das direkte Anordnen des Zwischenkreises in einem bereits vorhandenen Kühl- und/oder Absaugkanal einer Maschine, wird in vorteilhafter Weise eine Kühlung dieses Wärme abgebenden bzw. auf überhöhte Wärme empfindlich reagierenden Bauteils auf einfache und kostengünstige Art und Weise ermöglicht.

Hierbei kann der Zwischenkreis hineinragend in einen bereits vorhandenen Kanal angeordnet werden. Beispielsweise können am Zwischenkreis thermisch mit ihm verbundene Kühlrippen angeordnet sein, um die Kühlwirkung zu erhöhen, insbesondere wenn auch die Kühlrippen in den Kanal hineinragen.

Bevorzugt ist vorgesehen, den im oder am Kanal angeordneten Zwischenkreis mittels Steckverbindung und daher leicht auswechselbar elektrisch mit den übrigen Bauteilen der Frequenzumrichters zu verbinden.

Um eine Verschlechterung des Wärmeübergangs durch Verschmutzen, beispielsweise durch Entstehen einer Staub- oder Schmutzschicht an einer entsprechenden Fläche, durch ein Zusetzen der Kühlrippen durch Textilfussel etc. zu vermeiden, wird der Kühlstrom, vorzugsweise ein Luftstrom, in einer bevorzugten Ausführungsform der Erfindung vor dem Kühlen des Zwischenkreises mittels Filter gereinigt.

In weiterer Ausgestaltung der Erfindung ist der Zwischenkreis als separates Modul ausgebildet, welches vorzugsweise staubdicht gekapselt sein kann. Hierdurch kann auf einfache Art und Weise Beschädigung, Zerstörung und Verminderung der Kühlwirkung infolge einer Verschmutzung der Umgebungsluft vorgebeugt werden.

Weitere vorteilhafte Ausführungsformen ergeben sich aus den Unteransprüchen.

Nachfolgend wird die Erfindung anhand einer beispielsweisen Ausführungsformen näher erläutert. Die Darstellung zeigt ein Blockschaltbild der wesentlichen Komponenten eines Frequenzumrichters für Antriebsaggregate einer Textilmaschine, insbesondere einer Ringspinnmaschine oder Vorspinnmaschine. Ein Frequenzumrichter 1 besteht üblicherweise aus einem Steuerkreis 2, einem Gleichrichter 3, einem Zwischenkreis 4 und einem Wechselrichter 5. Am Gleichrichter 3 liegt eingangsseitig ein Wechsel-/Drehstromnetz 6 an, wobei die Wechselspannung gleichgerichtet wird und ausgangsseitig über Verbindung 7, 8 dem Zwischenkreis 4 als Gleichspannung zur Verfügung gestellt wird.

Als Zwischenkreis sind mehrere Varianten bekannt, nämlich Umformung der Spannung des Gleichrichters sowie Stabilisieren der pulsierenden Gleichspannung bzw. deren Glätten mittels einer Zwischenkreiskapazität. In dem dargestellten Ausführungsbeispiel wird auf Glättung und Stabilisierung mittels einer Zwischenkreiskapazität Bezug genommen (Darstellung des Kapazitätszeichens in Zwischenkreis 4), obwohl die Erfindung grundsätzlich nicht nur auf eine Zwischenkreiskapazität, sondern auf jede Wärme abgebende und/oder (gegen überhöhte Temperatur) wärmeempfindliche elektrische Komponente anwendbar ist.

Während der Stromfluss eingangsseitig vom Gleichrichter 3 über Leitungen 7, 8 zum Zwischenkreis 4 und ausgangsseitig über Leitungen 9,10 zum Wechselrichter 5 und von diesem zum Antriebsaggregat bzw. Motor 11 erfolgt, werden die vorgenannten Einzelkomponenten eines Frequenzumrichters über Steuerleitungen 12 vom Steuerkreis 2 beeinflusst bzw. gesteuert.

Erfindungswesentlich ist das Herauslösen bzw. die separate Ausbildung des Zwischenkreises 4 bzw. der Zwischenkreiskapazität aus dem Frequenzumrichter, wobei dessen übrige Komponenten, nämlich Steuerkreis 2, Gleichrichter 3 und Wechselrichter 5 ebenso wie der Zwischenkreis 4 als jeweils ein gesondertes Modul 13 bzw. 14 ausgeführt sein können. Die übrigen Komponenten des Frequenzumrichters können so vorteilhafter Weise örtlich getrennt von dem stark Wärme entwickelnden Zwischenkreis 4 an ihrer bevorzugten Position, beispielsweise im Schaltschrank oder im Bereich des Antriebsaggregates verbleiben.

Selbstverständlich muss der so heraus gelöste Zwischenkreis 4 nach wie vor über seine Leitungen 7, 8, 9, 10 sowie die Stromleitung 12 mit den anderen Komponenten des Frequenzumrichters verbunden sein. Er ist hierzu mittels Streckverbindungen 15 mit dem Modul 13 der Organe 3/4/5 verbunden. Es versteht sich, dass der Frequenzumrichters mittels nicht näher dargestellter Schraubverbindung oder anderweitiger rüttelsicherer Verbindung am Maschinengestelle befestigt ist.

Durch diese Herauslösbarkeit bzw. separate Ausbildung des Zwischenkreismoduls 14 ist es aber nunmehr möglich, diesen Zwischenkreis an oder in einem bereits vorhandenen, in dem im Querschnitt dargestellten Abluftkanal 16 anzuordnen. Dieser Abluftkanal dient beispielsweise als Absaugkanal für Textilfusseln und/oder gleichzeitig als Kühlkanal für das Antriebsaggregat selbst.

Wie dargestellt, kann der Wechselrichter 4 auch einen Wärmetauscher, insbesondere in Form von Kühlrippen 17, aufweisen, wobei es zur Kühlung ausreichen kann, dass die Kühlrippen in den Abluftkanal 16 hineinragen.

Wie anhand des vorstehenden Ausführungsbeispiels erläutert, ist es durch die separate Ausbildung eines Teils der Leistungselektronik, insbesondere des stark Wärme abgebenden Zwischenkreises ohne großen baulichen Aufwand, wie beispielsweise Ausbildung eines Extrakanals etc. nunmehr möglich, diesen Teil auf einfache und kostengünstige Art und Weise ausreichend zu kühlen.

Zudem sind durch die erfindungsgemäße separate Ausbildung und der hieraus folgen den leichteren Zugänglichkeit (Zwischenkreis 4 statt in der Nähe des Antriebsaggregates nunmehr im leichter zugänglichen Absaug- und/oder Kühlkanal 16 angeordnet) stark Wärme abgebende Teile von Leistungselektroniken im Falle eines Defekts leichter austauschbar. Dies insbesondere dann, wenn die Verbindungen zwischen den übrigen Komponenten 2, 3 und 5 des Frequenzumrichters und dem Zwischenkreises 4 über die Leitungen 7, 8, 9, 10 und 12 als Steckverbindungen 15 ausgebildet sind, die zu ihrem Lösen oder Verbinden keines Eingriffes bedürfen.

Befinden sich in dem Abluftkanal Verunreinigungen wie beispielsweise Staub, gebrochene Fadenenden, Fussel etc. so kann der Luftstrom, um Verunreinigungen und das Zusetzen der Kühlrippen 17 zu vermeiden, vor der Anordnung des Zwischenkreises 4 bzw. der Kühlrippen gefiltert werden. Hierzu kann im Abluftkanal 16 ein hier nicht näher dargestellter Filter angeordnet sein. Zudem kann die herauslösbare Einheit der Leistungselektronik, also beispielsweise der dargestellte Zwischenkreis 4, als staubdichte Einheit geschlossen ausgeführt werden, so dass ein Eindringen von Staub etc. in diese Einheit mit entsprechend nachteiligen Wirkungen vermieden werden kann.

Obwohl die Erfindung anhand des vorstehenden Ausführungsbeispiels eines Frequenzumrichters erläutert wurde, ist die Erfindung selbstverständlich auch auf andere, Wärme abgebende elektrische Komponenten anwendbar, indem sie aus einer Leistungselektronik herausgelöst werden und in oder an einem vorhandenen Abluft-, Absaug- oder Kühlkanal angeordnet werden. Selbstverständlich kann als Kühlmedium nicht nur Luft, sondern ein beliebiges Medium insbesondere auch flüssige Kühlmedien wie beispielsweise Wasser etc. verwendet werden.

Abschließend sei darauf hingewiesen, dass zuvor beschriebene Lösung, den Zwischenkreis mittels Steckverbindungen mit den übrigen Bauteilen 1/3/5 des Frequenzumrichters zu verbinden, als CAN-Bus-Lösung anzusehen ist.

### Bezugzahlenliste

1 Frequenzumrichter
1 Steuerkreis
3 Gleichrichter
4 Zwischenkreis
5 Wechselrichter
6 Wechsel-/Drehstromnetz
7, 8 Leitungen
9, 10 Leitungen
11 Antriebsaggregat
12 Steuerleitungen
13 Aggregatmodul
14 Zwischenkreismodul
15 Steckverbindungen
16 Abluftkanal
17 Kühlrippen

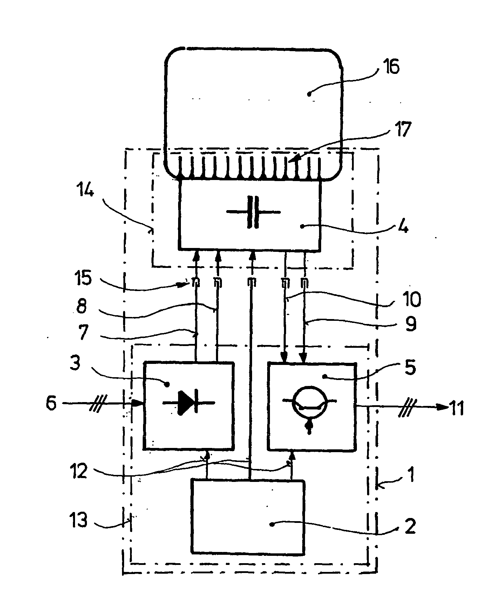

## Patentansprüche

1. Frequenzumrichter im Antrieb einer Textilmaschine, der
wenigstens einen Gleichrichter zum Gleichrichten von Wechselstrom,
wenigstens einen Zwischenkreis zum Glätten des pulsierenden Gleichstroms,
wenigstens einen Wechselrichter zum Erzeugen von Wechselstrom anderer Frequenz und
wenigstens eine Steuervorrichtung zum Steuern der Aggregate aufweist, **dadurch gekennzeichnet, dass** allein der Zwischenkreis (4) ausgeeinzelt und von den anderen Bauteilen des Frequenzumrichters (1) räumlich getrennt an einem vorzugsweise bereits in der Textilmaschine vorhandenen, durch einen kühlen Luftstrom durchströmten Kanal (16) angeordnet ist, wobei er über Steckverbindungen (15) mit den übrigen Bauteilen (2, 3, 5) des Frequenzumrichters verbunden ist..

2. Vorrichtung mit einem Frequenzumrichter nach Anspruch 1, **dadurch gekennzeichnet, dass** die Kühlwirkung durch das Vorsehen von wenigstens teilweise vom Kühlstrom durchflossene Kühlrippen (17) am Zwischenkreis (4) erhöht wird.

3. Vorrichtung mit einem Frequenzumrichter nach Anspruch 2, **dadurch gekennzeichnet, dass** der Kühlstrom vor dem Kühlen des Zwischenkreises (4) mittels Filter gereinigt wird.

4. Textilmaschine mit einer Vorrichtung nach einem der Ansprüche 1 bis 3.

## Claims

1. Frequency converter in the drive of a textile machine, said converter having
at least one rectifier for rectifying alternating current,
at least one intermediate circuit for smoothing the pulsating direct current,
at least one inverter for generating alternating current at another frequency, and
at least one control device for controlling the units, **characterized in that** only the intermediate circuit (4) is separated out and is arranged, such that it is spatially separate from the other components of the frequency converter (1), on a duct (16) which is preferably already present in the textile machine and through which a cool air stream flows, said intermediate circuit being connected to the other components (2, 3, 5) of the frequency converter by means of plug connections (15).

2. Device having a frequency converter according to Claim 1, **characterized in that** the cooling action is increased by providing, on the intermediate circuit (4), cooling ribs (17) through which the cooling stream at least partially flows.

3. Device having a frequency converter according to Claim 2, **characterized in that** the cooling stream is purified by means of filters before the intermediate circuit (4) is cooled.

4. Textile machine having a device according to one of Claims 1 to 3.

## Revendications

1. Convertisseur de fréquence dans le mécanisme d'entraînement d'une machine textile qui présente au moins un redresseur pour redresser un courant alternatif, au moins un circuit intermédiaire pour lisser le courant continu impulsionnel, au moins un onduleur pour générer un courant alternatif d'une fréquence différente et au moins un dispositif de commande pour commander les groupes, **caractérisé en ce** seul le circuit intermédiaire (4) est isolé et séparé dans l'espace des autres composants du convertisseur de fréquence (1) en étant installé sur un canal (16) de préférence déjà présent dans la machine textile et traversé par un courant d'air froid, le circuit intermédiaire étant relié avec les autres composants (2, 3, 5) du convertisseur de fréquence par le biais de connecteurs (15).

2. Dispositif muni d'un convertisseur de fréquence selon la revendication 1, **caractérisé en ce que** l'effet de refroidissement est accru en prévoyant sur le circuit intermédiaire (4) des ailettes de refroidissement (17) au moins partiellement traversées par le courant de refroidissement.

3. Dispositif muni d'un convertisseur de fréquence selon la revendication 2, **caractérisé en ce que** le courant de refroidissement est purifié au moyen d'un filtre avant le refroidissement du circuit intermédiaire (4).

4. Machine textile munie d'un dispositif selon l'une des revendications 1 à 3.
